# EUROPEAN PATENT APPLICATION

(11) **EP 4 797 920 A1**
(43) Date of publication of application: **26.08.2026**
(21) Application number: 25799166.1
(22) Date of filing: 04.08.2025
(51) Int. Cl.: H10K 59/126

(54) **DISPLAY PANEL AND DISPLAY DEVICE**

(30) Priority: 31.12.2024 CN 202411997388
(71) Applicant: Hubei Yangtze Industrial Innovation Center of Advanced Display Co., Ltd., East Lake Hi-tech Development Zone Wuhan, Hubei 430074 (CN)
(72) Inventor: CAI, Yu, Wuhan, Hubei 430074 (CN)
(74) Representative: Boult Wade Tennant LLP
(86) International application number: PCT/CN2025/112350
(87) International publication number: WO 2026/144139

(57) **Abstract**

The present disclosure provides a display panel and a display apparatus, and relates to the field of display technologies, which are for improving the aperture ratio of anti-peeping pixels. The display panel includes a substrate, a pixel layer, an encapsulation layer, and blocking structures. The pixel layer includes a first pixel. The encapsulation layer is provided at a side of the pixel layer facing away from the substrate, and is a single-layer film structure. Each of the blocking structures includes a first blocking portion and a second blocking portion. The first blocking portion is arranged at a side of the encapsulation layer facing away from the substrate, a first opening is formed between first blocking portions of adjacent blocking structures, the second blocking portion is arranged at a side of the first blocking portion facing away from the substrate, a second opening is formed between second blocking portions of adjacent blocking structures, and the first pixel, the first opening and the second opening at least partially overlap in a direction perpendicular to a plane of the substrate.

## Description

### CROSS-REFERENCE TO RELATED APPLICATIONS

The present application claims priority to Chinese Patent Application No. 202411997388.7, filed on December 31, 2024, the content of which is incorporated herein by reference in its entirety.

### TECHNICAL FIELD

The present disclosure relates to the field of display technologies, and in particular, to a display panel and a display apparatus.

### BACKGROUND

In today's digital age, information security and privacy protection are increasingly focused on, and an anti-peeping function of a display panel has emerged as an important feature in many electronic devices.

However, a structural design of an anti-peeping display panel in the related art will bring great restrictions to an aperture ratio design of anti-peeping pixels, making it difficult to improve an aperture ratio of the anti-peeping pixels.

### SUMMARY

Embodiments of the present disclosure provide a display panel and a display apparatus, which are for improving the aperture ratio of anti-peeping pixels.

In a first aspect, some embodiments of the present disclosure provide a display panel. The display panel includes a substrate, a pixel layer, an encapsulation layer, and blocking structures. The pixel layer includes a first pixel. The encapsulation layer is provided at a side of the pixel layer facing away from the substrate, and is a single-layer film structure. Each of the blocking structures includes a first blocking portion and a second blocking portion. The first blocking portion is arranged at a side of the encapsulation layer facing away from the substrate, a first opening is formed between first blocking portions of adjacent blocking structures, the second blocking portion is arranged at a side of the first blocking portion facing away from the substrate, a second opening is formed between second blocking portions of adjacent blocking structures, and the first pixel, the first opening and the second opening at least partially overlap in a direction perpendicular to a plane of the substrate.

In a second aspect, some embodiments of the present disclosure provides a method for manufacturing a display panel, including: forming a pixel layer at a side of a substrate. The pixel layer includes a first pixel; forming an encapsulation layer on the pixel layer. The encapsulation layer is formed as a single-layer film structure; and forming a blocking structure on the encapsulation layer. The blocking structure includes a first blocking portion and a second blocking portion, the first blocking portion is arranged at a side of the encapsulation layer facing away from the substrate, a first opening is formed between first blocking portions of adjacent blocking structures, the second blocking portion is arranged at a side of the first blocking portion facing away from the substrate, a second opening is formed between second blocking portions of adjacent blocking structures, and the first pixel, the first opening and the second opening at least partially overlap in a direction perpendicular to a plane of the substrate.

In a third aspect, some embodiments of the present disclosure provides a display apparatus including the above-described display panel.

The embodiments of the present disclosure have the following beneficial effects.

The display panel provided by the embodiments of the present disclosure adopts a single-layer encapsulation design. An encapsulation structure in such encapsulation manner is a very thin inorganic layer with a very small thickness. Therefore, when the first blocking portion is arranged above the first blocking portion, a longitudinal distance between the first blocking portion and the first pixel can be greatly reduced, so that the first blocking portion is very adjacent to the first pixel, and the first blocking portion can block light emitted by the first pixel 5 at a larger angle. Meanwhile, the second blocking portion is further arranged above the first blocking portion. Compared with the first blocking portion, a longitudinal distance between the second blocking portion and the first pixel is slightly larger, and the second blocking portion can block light emitted by the first pixel at a smaller angle.

By adopting the technical solution provided by the embodiments of the present disclosure, under the condition that the display panel reaches the same anti-peeping angle, a spacing between the adjacent first pixels can be reduced, so that the aperture ratio of the first pixel is larger, thereby effectively prolonging the service life of the first pixel.

### BRIEF DESCRIPTION OF THE DRAWINGS

In order to better illustrate the technical solutions in the embodiments of the present disclosure or the related art, the drawings used in the description of the embodiments will be briefly illustrated as follows. It should be noted that, the drawings described below are merely some of, rather than all of the embodiments of the present disclosure. Based on these drawings, those skilled in the art can obtain other drawings.
FIG. 1 is a structural diagram of a display panel in the related art;
FIG. 2 is a structural diagram of a display panel according to an embodiment of the present disclosure;
FIG. 3 is another structural diagram of a display panel according to an embodiment of the present disclosure;
FIG. 4 is a diagram of size comparison of first pixels according to an embodiment of the present disclosure;
FIG. 5 is a top view of a display panel according to an embodiment of the present disclosure;
FIG 6 is another top view of a display panel according to an embodiment of the present disclosure;
FIG. 7 is a sectional view along A1-A2 shown in FIG. 6;
FIG. 8 is yet another structural diagram of a display panel according to an embodiment of the present disclosure;
FIG. 9 is a structural diagram of a display panel according to an embodiment of the present disclosure;
FIG. 10 is a structural diagram of a display panel according to an embodiment of the present disclosure;
FIG. 11 is a structural diagram of a display panel according to an embodiment of the present disclosure;
FIG. 12 is a structural diagram of a display panel according to an embodiment of the present disclosure;
FIG. 13 is a structural diagram of a display panel according to an embodiment of the present disclosure;
FIG. 14 is a structural diagram of a display panel according to an embodiment of the present disclosure;
FIG. 15 is a structural diagram of a display panel according to an embodiment of the present disclosure;
FIG. 16 is a structural diagram of a display panel according to an embodiment of the present disclosure;
FIG. 17 is a structural diagram of a display panel according to an embodiment of the present disclosure;
FIG. 18 is a structural diagram of a display panel according to an embodiment of the present disclosure;
FIG. 19 is a structural diagram of a display panel according to an embodiment of the present disclosure;
FIG. 20 is a flowchart of a method for manufacturing a display panel according to an embodiment of the present disclosure;
FIG. 21 is another flowchart of a method for manufacturing a display panel according to an embodiment of the present disclosure;
FIG. 22 is yet another flowchart of a method for manufacturing a display panel according to an embodiment of the present disclosure;
FIG. 23 is a further flowchart of a method for manufacturing a display panel according to an embodiment of the present disclosure;
FIG. 24 is a further flowchart of a method for manufacturing a display panel according to an embodiment of the present disclosure; and
FIG. 25 is a structural diagram of a display apparatus according to an embodiment of the present disclosure.

### DETAILED DESCRIPTION

In order to better understand the technical solutions of the present disclosure, the following is a detailed description of the embodiments of the present disclosure with reference to the drawings.

It is to be made clear that the described embodiments are only some rather than all of the embodiments of the present disclosure. All other embodiments obtained by those skilled in the art based on the embodiments of the present disclosure without creative efforts should fall within a scope of the present disclosure.

Terms used in the embodiments of the present disclosure are merely for the purpose of describing specific embodiments, but not intended to limit the present disclosure. The singular forms of "a", "an" and "the" used in the embodiments of the present disclosure and the appended claims are also intended to include plural forms, unless clearly indicating others.

It should be understood that the term "and/or" used herein is merely an association relationship describing an associated object, indicating that there may be three relationships, for example, A and/or B, and may indicate: only A, both A and B, and only B. In addition, the character "/" herein generally indicates an "or" relationship between the associated objects.

Before describing the technical solutions provided by the embodiments of the present disclosure, the present disclosure first introduces the structure of the display panel in the related art.

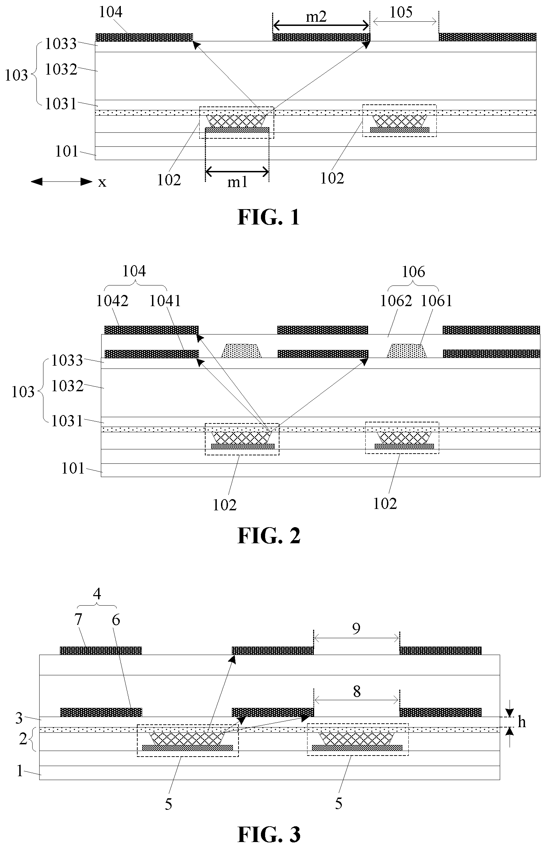

As shown in FIG. 1, which is a structural diagram of a display panel in the related art, the display panel includes a substrate 101, an anti-peeping pixel 102 arranged at a side of the substrate 101, an encapsulation layer 103 arranged at a side of the anti-peeping pixel 102 facing away from the substrate 101, and a blocking structure 104 arranged at a side of the encapsulation layer 103 facing away from the substrate 101.

The encapsulation layer 103 includes a first inorganic encapsulation layer 1031, an organic encapsulation layer 1032, and a second inorganic encapsulation layer 1033 that are stacked. An opening 105 is formed between adjacent blocking structures 104. In a direction perpendicular to a plane where the substrate 101 is arranged, the opening 105 overlaps the anti-peeping pixel 102.

In such a structure, a thicker encapsulation layer 103 is spaced between the blocking structure 104 and the anti-peeping pixel 102. The blocking structure 104 is far away from the anti-peeping pixel 102 longitudinally. If the blocking structure 104 is to be able to block light emitted by the anti-peeping pixels 102 at a larger angle, the adjacent anti-peeping pixels 102 need to be spaced sufficiently apart, thereby reducing the aperture ratio of the anti-peeping pixel 102 and greatly reducing the service life of the anti-peeping pixel 102.

For example, when a thickness of the first inorganic encapsulation layer 1031 and a thickness of the second inorganic encapsulation layer 1033 both are 1µm, and a thickness of the organic encapsulation layer 1032 is 17µm. Along a first direction x, a width m1 of the anti-peeping pixel 102 is 10µm, and a width m2 of the blocking structure 104 is 15µm, so that the light beyond 45° can be blocked to achieve anti-peeping with a viewing angle of more than 45°.

Based on this, in an embodiment of the present disclosure, the blocking structure 104 can be designed as a double-layer structure. As shown in FIG. 2, which is a structural diagram of a display panel according to an embodiment of the present disclosure, the blocking structure 104 includes a first blocking portion 1041 and a second blocking portion 1042. A side of the encapsulation layer 103 facing away from the substrate further includes a light extraction layer 106, and the light extraction layer 106 includes a dimming portion 1061 and a dimming layer 1062 that covers the dimming portion 1061. The dimming layer 1062 is spaced between the first blocking portion 1041 and the second blocking portion 1042. However, the improvement effect of this structure is still poor, and it is difficult to significantly improve the aperture ratio of the anti-peeping pixel.

In this regard, an embodiment of the present disclosure further provides a display panel, as shown in FIG. 3, which is another structural diagram of a display panel according to an embodiment of the present disclosure. The display panel includes a substrate 1, a pixel layer 2, an encapsulation layer 3 and multiple blocking structures 4.

The pixel layer 2 includes a first pixel 5, and the first pixel 5 is an anti-peeping pixel.

The encapsulation layer 3 is arranged at a side of the pixel layer 2 facing away from the substrate 1, and the encapsulation layer 3 is a single-layer film structure.

The blocking structure 4 includes a first blocking portion 6 and a second blocking portion 7. The first blocking portion 6 is arranged at a side of the encapsulation layer 3 facing away from the substrate 1, and e.g., can be arranged at a surface of the encapsulation layer 3 facing away from the substrate 1. In other words, the first blocking portion 6 is arranged adjacent to the encapsulation layer 3, and another layer is not spaced between the first blocking portion 6 and the encapsulation layer 3. A first opening 8 is formed between first blocking portions 6 of adjacent blocking structures 4. The second blocking portion 7 is arranged at a side of the first blocking portion 6 facing away from the substrate 1, and a second opening 9 is formed between second blocking portions 7 of adjacent blocking structures 4. In a direction perpendicular to the plane of the substrate 1, the first pixel 5, the first opening 8 at least partially overlaps the second opening 9.

Different from the foregoing structure, the display panel provided by the embodiments of the present disclosure adopts a single-layer encapsulation design. An encapsulation structure in such encapsulation manner is a very thin inorganic layer with a very small thickness. Therefore, when the first blocking portion 6 is arranged above the first blocking portion 6, a longitudinal distance between the first blocking portion 6 and the first pixel 5 can be greatly reduced, so that the first blocking portion 6 is very adjacent to the first pixel 5, and the first blocking portion 6 can block light emitted by the first pixel 5 at a larger angle. Meanwhile, the second blocking portion 7 is further arranged above the first blocking portion 6. Compared with the first blocking portion 6, a longitudinal distance between the second blocking portion 7 and the first pixel 5 is slightly larger, and the second blocking portion 7 can block light emitted by the first pixel 5 at a smaller angle.

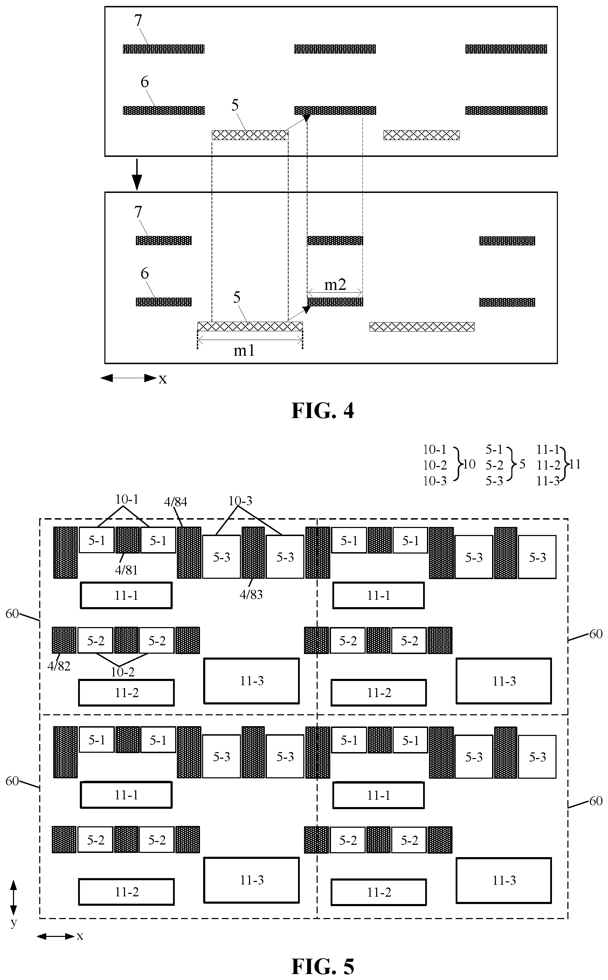

By adopting the technical solution provided by the embodiments of the present disclosure, as shown in FIG. 4, which is a diagram of size comparison of the first pixels 5 according to an embodiment of the present disclosure, under the condition that the display panel reaches the same anti-peeping angle, a spacing between the adjacent first pixels 5 can be reduced, so that the aperture ratio of the first pixel 5 is larger, for example, along the first direction x, the width m1 of the first pixel 5 can be greater than or equal to the width m2 of the blocking structure 4, thereby effectively prolonging the service life of the first pixel 5.

In an embodiment of the present disclosure, the encapsulation layer 3 is an inorganic layer, and may include an oxide material, for example, an aluminum oxide material.

In an embodiment of the present disclosure, the encapsulation layer 3 may be formed by an atomic layer deposition (ALD) process. A single-layer encapsulation film formed by the process has a very high compactness, effectively blocking intrusion of external substances such as water vapor, oxygen, and impurities, thereby achieving a good encapsulation effect.

In an embodiment of the present disclosure, referring to FIG. 3, a thickness h of the encapsulation layer 3 is less than 1µm. Further, 30nm ≤ h ≤ 100nm.

The encapsulation layer 3 with this thickness is very thin. When the first blocking portion 6 is arranged above the encapsulation layer 3, the longitudinal distance between the first blocking portion 6 and the first pixel 5 can be compressed to a large extent, so that the first blocking portion 6 can block light emitted by the first pixel 5 at a larger angle, thereby improving the aperture ratio of the first pixel 5 to a greater extent when the display panel reaches the same anti-peeping angle.

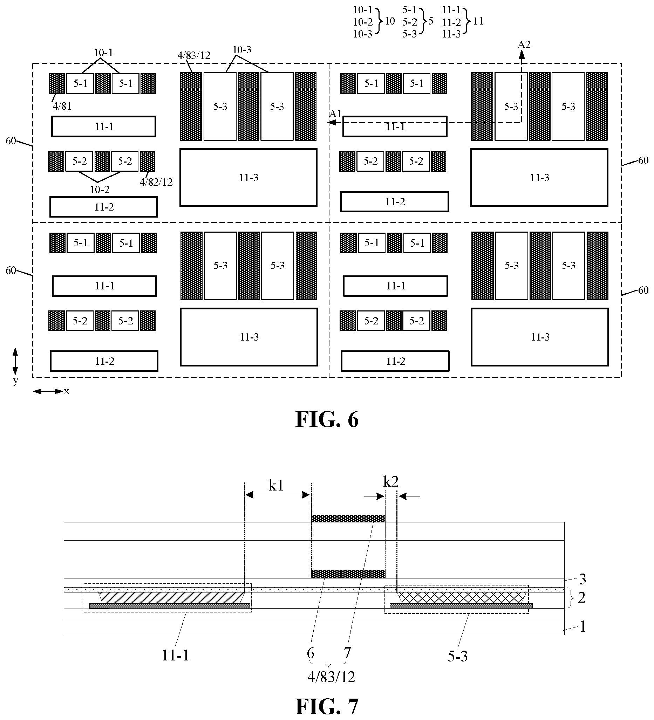

In an embodiment of the present disclosure, as shown in FIG. 5 and FIG. 6, FIG. 5 is a top view of a display panel according to an embodiment of the present disclosure, and FIG. 6 is another top view of a display panel according to an embodiment of the present disclosure. The pixel layer 2 includes a first display unit 10, and the first display unit 10 includes at least two first pixels 5 of a same color arranged along the first direction x.

With reference to FIG. 7, the pixel layer 2 further includes a second pixel 11. The second pixel 11 is a shared pixel, and an area of the second pixel 11 is greater than an area of the first pixel 5 of the same color.

On the plane of the substrate 1, an orthographic projection of the first pixel 5 has orthographic projections of the blocking structure 4 at least at opposite sides of the first direction x.

Taking the first direction x as the left-right viewing angle direction, and the display panel performing left-right anti-peeping as an example: the display panel has an anti-peeping mode and a sharing mode. In the sharing mode, the second pixel 11 emits light, and the first pixel 5 may or may not emit light. The user can normally view a picture at both left and right viewing angles. In the anti-peeping mode, the first pixel 5 emits light, and the second pixel 11 does not emit light. The light at the left and right viewing angles emitted by the first pixel 5 is blocked by the blocking structures 4 at the left and right sides thereof, so that the user can view the picture a front viewing angle, but cannot view the picture at the left and right viewing angles, and the display panel can achieve anti-peeping at the left and right viewing angles.

The first display unit 10 is an anti-peeping display unit. Such a structure may be understood as dividing the pixels in the first display unit 10 into at least two anti-peeping pixels (the first pixel 5) having a smaller size and arranged along the first direction x by pixel segmentation. In this way, each of the anti-peeping pixels is provided with a blocking structure 4 at each of the left and right sides, and the light at the left and right viewing angles emitted by each of the anti-peeping pixels can be blocked to a greater extent by the blocking structure 4 on the two sides thereof, so that the anti-peeping effect is better at the left and right viewing angles. Compared with directly designing the area of the first pixel 5 to be the same as the area of the second pixel 11, this pixel segmentation design can enable the display panel to achieve a better anti-peeping effect.

In an optional structure, the first pixel 5 includes a first-type first pixel 5-1, a second-type first pixel 5-2, and a third-type first pixel 5-3. The second pixels 11 include a first-type second pixels 11-1, a second-type second pixel 11-2, and a third-type second pixel 11-3.

The first-type first pixel 5-1 and the first-type second pixel 11-1 have the same color, the second-type first pixel 5-2 and the second-type second pixel 11-2 have the same color, and the third-type first pixel 5-3 and the third-type second pixel 11-3 have the same color. Exemplarily, the color of the third-type first pixel 5-3 is blue. The color of one of the first-type first pixel 5-1 and the second-type first pixel 5-2 is red, and the color of the other of the first-type first pixel 5-1 and the second-type first pixel 5-2 is green.

The first display unit 10 includes a first-type first display unit 10-1, a second-type first display unit 10-2, and a third-type first display unit 10-3. The first-type first display unit 10-1 includes at least two first-type first pixels 5-1 arranged along the first direction x, the second-type first display unit 10-2 includes at least two second-type first pixels 5-2 arranged along the first direction x, and the third-type first display unit 10-3 includes at least two third-type first pixels 5-3 arranged along the first direction x.

The display panel includes multiple repeating units 60. The repeating unit 60 includes a first-type first display unit 10-1, a first-type second pixel 11-1, a second-type first display unit 10-2, and a second-type second pixel 11-2 that are arranged along a second direction y, and includes a third-type first display unit 10-3 and a third-type second pixel 11-3 that are arranged along the second direction y. The second direction y intersects the first direction x.

In one structure, referring to FIG. 5, in the repeating unit 60, along the first direction x, the third-type first display unit 10-3 overlaps the first-type first display unit 10-1, and two third-type first pixels 5-3 and two first-type first pixels 5-1 that are adjacent to each other, respectively, in the third-type first display unit 10-3 and the first-type first display unit 10-1 both can share a blocking structure 4.

That is, with such a structure, the blocking structure 4 includes a first sub-blocking structure 81, a second sub-blocking structure 82, a third sub-blocking structure 83, and a fourth sub-blocking structure 84.

In a direction perpendicular to a plane of the substrate 1, an orthographic projection of the first sub-blocking structure 81 is arranged between orthographic projections of two adjacent first-type first pixels 5-1, an orthographic projection of the second sub-blocking structure 82 is arranged at two opposite sides of an orthographic projection of the second-type first pixel 5-2 in the first direction x, an orthographic projection of the third sub-blocking structure 83 is arranged between orthographic projections of two adjacent third-type first pixels 5-3, and an orthographic projection of the fourth sub-blocking structure 84 is arranged between orthographic projections of the adjacent first-type first pixels 5-1 and orthographic projections of the third-type first pixels 5-3. The fourth sub-blocking structure 84 is configured to block light emitted by the first-type first pixels 5-1 and the third-type first pixels 5-3.

When the color of the third-type first pixel 5-3 is blue, a size of the third-type first pixel 5-3 in the second direction y is greater than sizes of the first-type first pixel 5-1 and the second-type first pixel 5-2 in the second direction y.

In this regard, in order to ensure that the fourth sub-blocking structure 84 and the third sub-blocking structure 83 can effectively block the light of the third-type first pixel 5-3, along the second direction y, the width of the fourth sub-blocking structure 84 can be configured to be greater than the width of the first sub-blocking structure 81 and the width of the second sub-blocking structure 82, and the width of the third sub-blocking structure 83 can be configured to be greater than the width of the first sub-blocking structure 81 and the width of the second sub-blocking structure 82.

Further, along the first direction x, when the third-type first display unit 10-3 only partially overlaps the first-type first display unit 10-1, the width of the fourth sub-blocking structure 84 in the second direction y can be configured to be greater than the size of the third-type first pixel 5-3 in the second direction y, so that along the first direction x, the first-type first pixel 5-1 can completely overlap the fourth sub-blocking structure 84, the third-type first pixel 5-3 can also completely overlap the fourth sub-blocking structure 84, and the fourth sub-blocking structure 84 can effectively block the light of the first-type first pixel 5-1 and the third-type first pixel 5-3 on both sides thereof. In this case, the width of the third sub-blocking structure 83 in the second direction y may be consistent with the width of the fourth sub-blocking structure 84 in the second direction y.

Exemplarily, along the second direction y, the width of the fourth sub-blocking structure 84 is 1.5 times or more of the width of the first sub-blocking structure 81.

Further, referring to FIG. 5 again, along the first direction x, the third-type first display unit 10-3 does not overlap the first-type second pixel 11-1, and the fourth sub-blocking structure 84 does not overlap the first-type second pixel 11-1, so as to prevent the fourth sub-blocking structure 84 from affecting normal light emission of the first-type second pixel 11-1.

In addition, referring to FIG. 5 again, along the first direction x, the third-type second pixel 11-3 overlaps the second-type second pixel 11-2, but does not overlap the second-type first display unit 10-2, which can prevent the second sub-blocking structure 82 from affecting the light emission of the third-type second pixel 11-3.

Alternatively, in another structure, different types of first pixels 5 may not share the blocking structure 4. For example, referring to FIG. 6, along the first direction x, the third-type first display unit 10-3 overlaps the first-type first display unit 10-1, but two third-type first pixels 5-3 and two first-type first pixels 5-1 that are adjacent to each other, respectively, in the third-type first display unit 10-3 and the first-type first display unit 10-1 do not share the blocking structure 4.

That is, with such a structure, the blocking structure 4 includes a first sub-blocking structure 81, a second sub-blocking structure 82, and a third sub-blocking structure 83.

In a direction perpendicular to the plane of the substrate 1, the orthographic projection of the first sub-blocking structure 81 is arranged at an opposite side of the orthographic projection of the first-type first pixel 5-1 in the first direction x, the orthographic projection of the second sub-blocking structure 82 is arranged at an opposite side of the orthographic projection of the second-type first pixel 5-2 in the first direction x, and the orthographic projection of the third sub-blocking structure 83 is arranged at an opposite side of the orthographic projection of the third-type first pixel 5-3 in the first direction x.

When the color of the third-type first pixel 5-3 is blue, a size of the third-type first pixel 5-3 in the second direction y is greater than sizes of the first-type first pixel 5-1 and the second-type first pixel 5-2 in the second direction y.

In this regard, in order to ensure that the third sub-blocking structure 83 can effectively block the light of the third-type first pixel 5-3, along the second direction y, the width of the third sub-blocking structure 83 can be configured to be greater than the width of the first sub-blocking structure 81 and the width of the second sub-blocking structure 82.

Further, with reference to FIG. 6 and FIG. 7, FIG. 7 is a sectional view along A1-A2 shown in FIG. 6n. Along the first direction x, at least part of the second pixels 11 overlaps the first pixels 5. Exemplarily, referring to FIG. 6, along the first direction x, the first-type second pixel 11-1 overlaps the third-type first pixel 5-3, and the third-type second pixel 11-3 overlaps the second-type first pixel 5-2.

The blocking structure 4 includes a first blocking structure 12. On a plane of the substrate 1, an orthographic projection of the first blocking structure 12 is arranged between an orthographic projection of the second pixel 11 and an orthographic projection of the first pixel 5. A distance k1 between the orthographic projection of the first blocking structure 12 and the orthographic projection of the second pixel 11 is greater than a distance k2 between the orthographic projection of the first blocking structure 12 and the orthographic projection of the first pixel 5.

Exemplarily, referring to FIG. 6, the first blocking structure 12 includes a third sub-blocking structure 83. On the plane of the substrate 1, an orthographic projection of the third sub-blocking structure 83 is arranged between the orthographic projection of the first-type second pixel 11-1 and the orthographic projection of the third-type first pixel 5-3. A distance between the orthographic projection of the third sub-blocking structure 83 and the orthographic projection of the first-type second pixel 11-1 is greater than a distance between the orthographic projection of the third sub-blocking structure 83 and the orthographic projection of the third-type first pixel 5-3.

The blocking structure 12 includes a second sub-blocking structure 82. On the plane of the substrate 1, an orthographic projection of the second sub-blocking structure 82 is arranged between the orthographic projection of the third-type second pixel 11-3 and the orthographic projection of the second-type first pixel 5-2. A distance between the orthographic projection of the second sub-blocking structure 82 and the orthographic projection of the third-type second pixel 11-3 is greater than a distance between the orthographic projection of the second sub-blocking structure 82 and the orthographic projection of the second-type first pixel 5-2.

The distance between the first blocking structure 12 and the second pixel 11 is configured to be greater than the distance between the first blocking structure 12 and the first pixel 5, so that the first blocking structure 12 can block oblique viewing angle light emitted by the first pixel 5 without blocking the light emitted by the second pixel 11 on a side thereof, thereby avoiding affecting the display effect in the sharing mode.

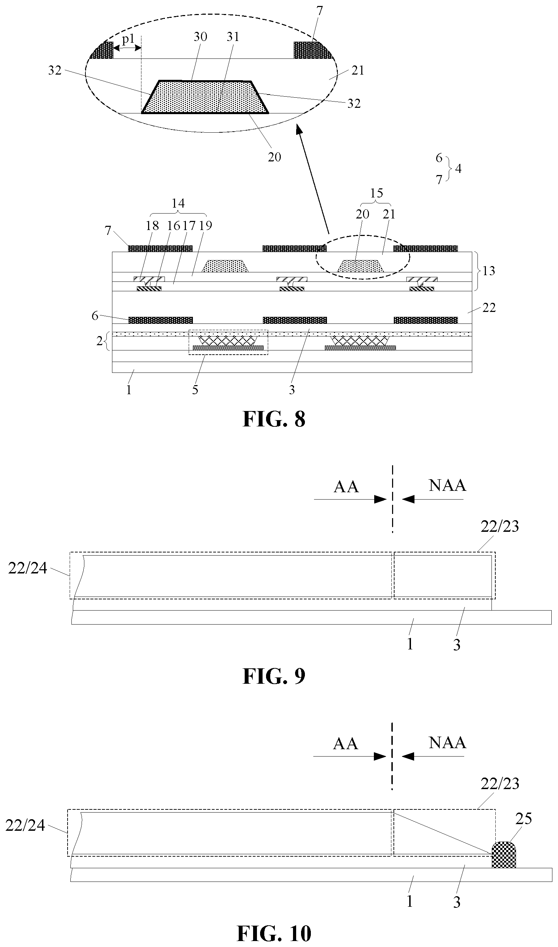

In an embodiment of the present disclosure, as shown in FIG. 8, which is yet another structural diagram of a display panel according to an embodiment of the present disclosure, a spacing is formed between the first blocking portion 6 and the second blocking portion 7 along the direction perpendicular to the plane of the substrate 1.

That is, other layers are spaced between the first blocking portion 6 and the second blocking portion 7. As a result, a longitudinal distance between the second blocking portion 7 and the first pixel 5 can be flexibly adjusted by designing parameters such as the number of layers and the thickness between the first blocking portion 6 and the second blocking portion 7, thereby adjusting a minimum shading angle that the blocking structure 4 can have, and improving the flexibility of designing the anti-peeping angle of the display panel. Therefore, under the condition that the display panel reaches the same anti-peeping angle, a spacing between adjacent first pixels 5 can be reduced, so that the aperture ratio of the first pixels 5 is greater.

In an embodiment of the present disclosure, referring to FIG. 8 again, the display panel further includes a first layer 13 that is arranged between the first blocking portion 6 and the second blocking portion 7, and the first layer 13 includes a touch layer 14 and/or a light extraction layer 15.

The touch layer 14 may include a first electrode layer 16, a first insulating layer 17, a second electrode layer 18, and a second insulating layer 19 that are stacked in a direction facing away from the substrate 1. One of the first electrode layer 16 and the second electrode layer 18 includes a touch electrode, and the other of the first electrode layer 16 and the second electrode layer 18 includes a touch signal line.

The light extraction layer 15 may include multiple dimming portions 20 and a dimming layer 21 that is covering the dimming portions 20. The first pixel 5 and the second pixel 11 overlap the dimming portions 20 in the direction perpendicular to the plane of the substrate 1. Exemplarily, in the direction perpendicular to the plane of the substrate 1, a spacing is formed between an edge of the orthographic projection of the first pixel 5 and an edge of the orthographic projection of the dimming portion 20, and the spacing may be, for example, about 2.02µm. A refractive index of the dimming portion 20 is different from a refractive index of the dimming layer 21. For example, the refractive index of the dimming portion 20 is greater than the refractive index of the dimming layer 21. After the light emitted by the first pixel 5 and the second pixel 11 enters the light extraction layer 15, the light is refracted at an interface between the dimming portion 20 and the dimming layer 21, so that the light with a large angle is converted into light with a small angle, thereby improving the light emission brightness at a front viewing angle.

The display panel further includes an organic spacer layer 22 arranged between the first layer 13 and the first blocking portion 6.

In the layer structure of the display panel, a thickness of the organic layer is usually much greater than a thickness of the inorganic layer. An organic spacer layer 22 is provided between the first layer 13 and the first blocking portion 6. On one hand, the organic spacer layer 22 is spaced between the touch layer 14 and the pixel layer 2, which can reduce mutual interference between the touch signal and the display signal. And/or, the organic spacer layer 22 is spaced between the light extraction layer 15 and the pixel layer 2, so that the light extraction layer 15 is far apart from the pixel layer 2, and more oblique light emitted by the first pixel 5 and the second pixel 11 can be injected into the interface between the dimming portion 20 and the dimming layer 21, thereby further improving a light extraction rate. On the other hand, the second blocking portion 7 is far apart from the first pixel 5, and the second blocking portion 7 can block light emitted by the first pixel 5 at a smaller angle, thereby improving the anti-peeping effect.

Further, the thickness of the organic spacer layer 22 may be configured to be greater than 10µm, so that a sufficient spacing is formed between the pixel layer 2 and the touch layer 14, the light extraction layer 15, and the second blocking portion 7.

In an embodiment of the present disclosure, a dielectric constant of the organic spacer layer 22 is ε1, where 2.3 ≤ ε1 ≤ 3. The dielectric constant of the organic spacer layer 22 is relatively low, thereby further reducing the mutual interference between the touch layer 14 and the pixel layer 2 and ensuring the touch performance.

In an embodiment of the present disclosure, the organic spacer layer 22 includes an organic photoresist material.

The organic spacer layer 22 includes the organic photoresist material, which means that the organic spacer layer 22 can be formed by an etching process. As shown in FIG. 9, which is another structural diagram of a display panel according to an embodiment of the present disclosure, the organic spacer layer 22 formed by the etching process has a uniform thickness and a better film flatness. In particular, the display panel includes a display area AA and a non-display area NAA that is arranged at a side of the display area AA. The organic spacer layer 22 includes a first portion 23 arranged in the non-display area NAA and a second portion 24 at least arranged in the display area AA, and a thickness of the first portion 23 is equal to a thickness of the second portion 24.

In an embodiment of the present disclosure, the organic spacer layer 22 can also be formed by an inkjet printing process. During the inkjet printing process, ink droplets in the central region can be relatively uniformly overlapped and spread, while in the edge region, the deposition distribution of the droplets changes, making the thickness in the edge region smaller.

As shown in FIG. 10, which is another structural diagram of a display panel according to an embodiment of the present disclosure, the display panel includes a display area AA and a non-display area NAA that is arranged at a side of the display area AA. The organic spacer layer 22 includes a first portion 23 arranged in the non-display area NAA and a second portion 24 at least arranged in the display area AA, and a thickness of the first portion 23 is less than a thickness of the second portion 24. For example, the thickness of the first portion 23 decreases gradually along a direction from the display area AA to the non-display area NAA.

The layer formed by the inkjet printing process can have a larger thickness. When the organic spacer layer 22 is formed by the inkjet printing process, the thickness of the organic spacer layer 22 can be configured within a larger range, thereby facilitating more flexible adjustment of the longitudinal distance between the second blocking portion 7 and the first pixel 5 and adjustment of the shading angle of the second blocking portion 7.

Further, referring to FIG. 10 again, the display panel further includes a blocking dam 25 that is arranged in the non-display area NAA and arranged between the organic spacer layer 22 and an outer edge of the display panel.

During the printing process, after an ink is sprayed from a nozzle, the ink can have a tendency to spread naturally under the action of surface tension. By configuring the blocking dam 25, the blocking dam 25 can be used to block the ink from exceeding a set printing area, and the ink is limited within a specific range, thereby ensuring that the ink is deposited according to a preset pattern or area.

It should be noted that, different from the organic spacer layer 22 formed by the printing process, when the organic spacer layer 22 is formed by the etching process, since the organic photoresist material has almost no fluidity during the etching process, the barrier dam 25 does not need to be arranged near the outer edge of the display panel.

In an embodiment of the present disclosure, referring to FIG. 9 again, on the plane of the substrate 1, an orthographic projection of the organic spacer layer 22 overlaps an orthographic projection of the encapsulation layer 3. In one process, after the organic spacer layer 22 is formed, the organic spacer layer 22 can be regarded as a mask, and then the encapsulation layer 3 in the area outside the area covered by the organic spacer layer 22 is etched away, so that an edge of the encapsulation layer 3 is kept flush with an edge of the organic spacer layer 22.

When the edge of the encapsulation layer 3 is flush with the edge of the organic spacer layer 22, under an influence of external forces such as thermal expansion and cold contraction, and mechanical vibration, the stress can be more uniformly distributed on the entire encapsulation structure, which can reduce the stress concentration phenomenon caused by uneven edges, thereby preventing issues such as cracks or delamination in the encapsulation layer 3 or the organic spacer layer 22 due to stress concentration, and improving the structural stability of the display panel.

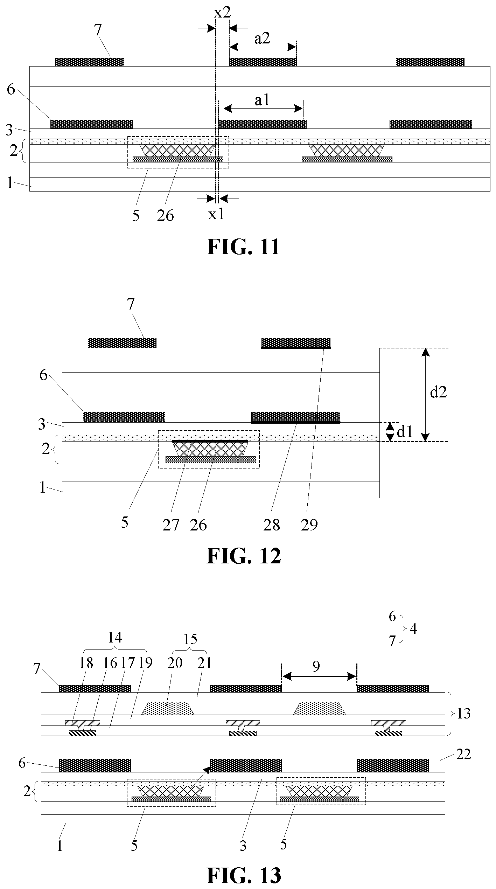

In an embodiment of the present disclosure, as shown in FIG. 11, which is a structural diagram of another display panel according to an embodiment of the present disclosure, along the first direction x, a width of the first blocking portion 6 is greater than a width of the second blocking portion 7.

That is, along the first direction x, the width of the first blocking portion 6 is a1, and the width of the second blocking portion 7 is a2, where 0 < a2/a1 < 1. Exemplarily, the width a1 of the first blocking portion 6 can be designed to be 14µm, 16µm, etc., and the width a2 of the second blocking portion 7 can be designed to be 10µm, etc.

In the blocking structure 4, the first blocking portion 6 is adjacent to the pixel layer 2, and the first blocking portion 6 is mainly configured to block light emitted by the first pixel 5 at a larger angle, so that the first blocking portion 6 largely determines how much the maximum anti-peeping angle of the display panel can reach. Further, the width of the first blocking portion 6 can greatly affect an angle range of the light that can be blocked by the first blocking portion 6. Therefore, in an embodiment of the present disclosure, the width of the first blocking portion 6 and the width of the second blocking portion 7 can be designed differently. The first blocking portion 6 can be configured wider, and the first blocking portion 6 can be used to block light at a larger angle, so that the anti-peeping angle range of the display panel can be larger.

Further, referring to FIG. 11, on the plane of the substrate 1, a distance between an edge of the orthographic projection of the first blocking portion 6 and an edge of the orthographic projection of the first pixel 5 is x1, where x1 ≥ 0, to prevent the first blocking portion 6 from blocking the first pixel 5. A distance between an edge of the orthographic projection of the second blocking portion 7 and an edge of the orthographic projection of the light-emitting layer 26 is x2, where x2 > x1.

In an embodiment of the present disclosure, as shown in FIG. 12, which is another structural diagram of a display panel according to an embodiment of the present disclosure, the first pixel 5 includes a light-emitting layer 26, and the light-emitting layer 26 includes a first top surface 27 facing away from the substrate 1.

The first blocking portion 6 includes a first bottom surface 28 adjacent to the substrate 1, and the second blocking portion 7 includes a second bottom surface 29 adjacent to the substrate 1.

A distance between the first top surface 27 and the first bottom surface 28 in a direction perpendicular to the plane of the substrate 1 is d1, and a distance between the first top surface 27 and the second bottom surface 29 in a direction perpendicular to the plane the substrate 1 is arranged is d2, where 10 < d2/d1 < 50.

In an embodiment of the present disclosure, the first blocking portion 6 is arranged above the encapsulation layer 3. In an embodiment of the present disclosure, since the encapsulation layer 3 is a single-layer encapsulation, a longitudinal distance d1 between the first blocking portion 6 and the light-emitting layer 26 is smaller, which is adjacent to the thickness of the encapsulation layer 3. On this basis, when configuring a longitudinal distance d2 between the second blocking portion 7 and the light-emitting layer 26, by setting the minimum value of a ratio between d2 and d1 to 10, the second blocking portion 7 and the light-emitting layer 26 can be ensured to be spaced a sufficient distance, so that the second blocking portion 7 can block light emitted by the first pixel 5 at a small angle, thereby ensuring the minimum anti-peeping angle of the display panel. Further, the maximum value of the ratio between d2 and d1 is set to 50, further preventing the second blocking portion 7 from being spaced too far away from the light-emitting layer 26 to affect the module thickness of the display panel.

Exemplarily, d1<1µm, and d2>10µm, for example, d2=17µm.

In an embodiment of the present disclosure, referring to FIG. 8, the display panel further includes a light extraction layer 15 that is arranged between the first blocking portion 6 and the second blocking portion 7.

The light extraction layer 15 includes multiple dimming portions 20 and a dimming layer 21 that covers the dimming portions 20. The first pixel 5 overlaps the dimming portions 20 in the direction perpendicular to the plane of the substrate 1. The dimming portion 20 includes a first surface 30 and a second surface 31 opposite to each other, and a first inclined surface 32 that is connected between the first surface 30 and the second surface 31. In the direction perpendicular to the plane of the substrate 1, the second blocking portion 7 does not overlap the first inclined surface 32.

Exemplarily, a distance p1 between an orthographic projection of the second blocking portion 7 on the substrate 1 and an orthographic projection of the first inclined surface 32 on the substrate 1 is about 1.6µm.

In the light extraction layer 15, a refractive index of the dimming portion 20 is different from a refractive index of the dimming layer 21. For example, the refractive index of the dimming portion 20 is greater than the refractive index of the dimming layer 21. After the light emitted by the first pixel 5 and the second pixel 11 enters the light extraction layer 15, the light is refracted at an interface between the dimming portion 20 and the dimming layer 21, so that the light with a large angle is converted into light with a small angle, thereby improving the light emission brightness at a front viewing angle. Therefore, the first inclined surface 32 of the dimming portion 20 is a main surface that acts on light. When the second blocking portion 7 is provided, the second blocking portion 7 does not overlap the first inclined surface 32, preventing the second blocking portion 7 from affecting the dimming effect on the light extraction layer 15, and ensuring that the display panel has a higher light extraction rate.

In an embodiment of the present disclosure, as shown in FIG. 13, which is another structural diagram of a display panel according to an embodiment of the present disclosure, a thickness of the first blocking portion 6 is greater than a thickness of the second blocking portion 7, so that a side wall of the first blocking portion 6 blocks more oblique light, thereby reducing a risk of the oblique light exiting the panel through the adjacent second opening 9.

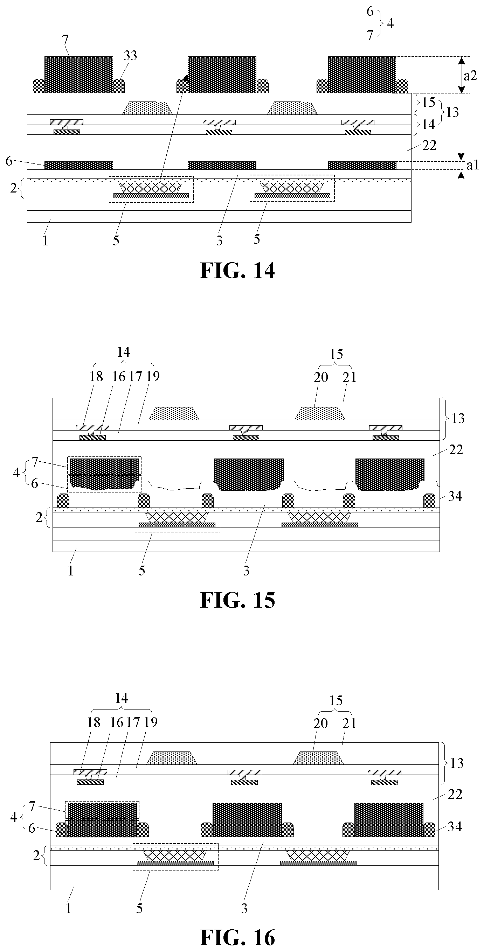

In an embodiment of the present disclosure, as shown in FIG. 14, which is another structural diagram of a display panel according to an embodiment of the present disclosure, a thickness of the second blocking portion 7 is greater than a thickness of the first blocking portion 6.

In the blocking structure 4, the second blocking portion 7 is mainly configured to block light emitted by the first pixel 5 at a smaller angle, and a thickness of the second blocking portion 7 can greatly affect an angle range of light that can be blocked by the second blocking portion 7. Therefore, in an embodiment of the present disclosure, the thickness of the first blocking portion 6 and the thickness of the second blocking portion 7 can be designed differently, and the second blocking portion 7 can be configured thicker, so that the side wall of the second blocking portion 7 can block more light at a smaller angle, thereby enabling the display panel to have a larger anti-peeping angle range.

Further, referring to FIG. 14 again, the thickness of the first blocking portion 6 is a1, and the thickness of the second blocking portion 7 is a2. a2/a1 can satisfy: 3 < a2/a1 < 50.

The minimum value of the ratio between a2 and a1 is set to be 3, ensuring that the second blocking portion 7 has a sufficient thickness to block more light. The maximum value of the ratio between a2 and a1 is set to be 50, preventing the second blocking portion 7 from being too thick to cause the module thickness of the display panel to be larges, thereby avoiding affecting the light and thin design of the display panel.

In an embodiment of the present disclosure, in order to ensure that the second blocking portion 7 has a larger thickness, the thickness of the second blocking portion 7 can be set to be greater than 10µm, so as to block more light at a smaller angle.

Further, referring to FIG. 14, the display panel further includes a first dam 33 arranged around the second blocking portion 7.

In an embodiment of the present disclosure, the second blocking portion 7 can be formed by the inkjet printing process. In such pixel-level inkjet printing, a first dam 33 can be provided around the printing area, to block diffusion of ink at an edge of the printing area using the first dam 33, ensuring that the ink of each pixel can be accurately deposited at a predetermined position, thereby ensuring pixel-level accuracy of a printed image. In addition, the first dam 33 can also limit and guide the flow of the ink during the printing process, so that the flow of the ink in the printing area is more stable and uniform, and the printing consistency is prevented from being affected due to uneven flow of the ink.

In an embodiment of the present disclosure, as shown in FIG. 15, which is another structural diagram of a display panel according to an embodiment of the present disclosure, the first blocking portion 6 and the second blocking portion 7 in the blocking structure 4 are integrally formed, and the first blocking portion 6 and the second blocking portion 7 are in communication with each other without a spacing therebetween. The blocking structure 4 with such a structure can form the first blocking portion 6 and the second blocking portion 7 simultaneously by only one process, and the process is simpler.

In an embodiment of the present disclosure, when the first blocking portion 6 and the second blocking portion 7 are integrally formed, a thickness of the blocking structure 4 is greater than 10µm, ensuring that the blocking structure 4 has a sufficient thickness to block light within a larger angle range. Under the condition that the display panel reaches the same anti-peeping angle, a spacing between adjacent first pixels 5 can be reduced, so that the aperture ratio of the first pixels 5 is greater.

In an embodiment of the present disclosure, referring to FIG. 15 again, the display panel further includes a second dam 34 that is arranged at a side of the pixel layer 2 facing away from the substrate 1. On the plane of the substrate 1, an orthographic projection of the second dam 34 is arranged around an orthographic projection of the blocking structure 4.

In an embodiment of the present disclosure, the blocking structure 4 can be formed by an inkjet printing process. In such pixel-level inkjet printing, a second dam 34 can be arranged around the printing area, and the second dam 34 can effectively block the diffusion of ink at an edge of the printing area, ensuring that the ink of each pixel can be accurately deposited at a predetermined position, thereby ensuring pixel-level accuracy of a printed image. In addition, the second dam 34 can also limit and guide the flow of the ink during the printing process, so that the flow of the ink in the printing area is more stable and uniform, and the printing consistency is prevented from being affected due to uneven flow of the ink.

Further, referring to FIG. 15 again, the second dam 34 is arranged between the pixel layer 2 and the encapsulation layer 3, that is, the second dam 34 is formed before the encapsulation layer 3 is formed.

As described above, the encapsulation layer 3 in an embodiment of the present disclosure is a single-layer encapsulation, which is very thin. Therefore, when the second dam 34 is arranged between the pixel layer 2 and the encapsulation layer 3, the encapsulation layer 3 may be uneven, and the upper surface of the encapsulation layer 3 may be undulating. Such layer undulation can still limit the flow of ink, and prevent diffusion thereof, thereby achieving more accurate pixel-level inkjet printing, and making the position of the blocking structure 4 more accurate.

Further, an upper surface of the encapsulation layer 3 facing away from the substrate 1 is an uneven surface, that is, when the second dam 34 is arranged at a lower side of the encapsulation layer 3, the encapsulation layer 3 may be lifted up, so that the encapsulation layer 3 is uneven, and the encapsulation layer 3 may be concave in a region between the second dams 34, thereby restricting the flow of ink.

Alternatively, as shown in FIG. 16, which is another structural diagram of a display panel according to an embodiment of the present disclosure, the second dam 34 is arranged at a side of the encapsulation layer 3 facing away from the substrate 1, that is, the second dam 34 is formed after the encapsulation layer 3 is formed.

The second dam 34 is arranged above the encapsulation layer 3. The second dam 34 is in direct contact with the ink during ink jetting, and the second dam 34 blocks the flow of ink more obviously, ensuring the pixel-level accuracy of the printed image to a greater extent, and reducing the risk of deviation in the formation position of the blocking structure 4.

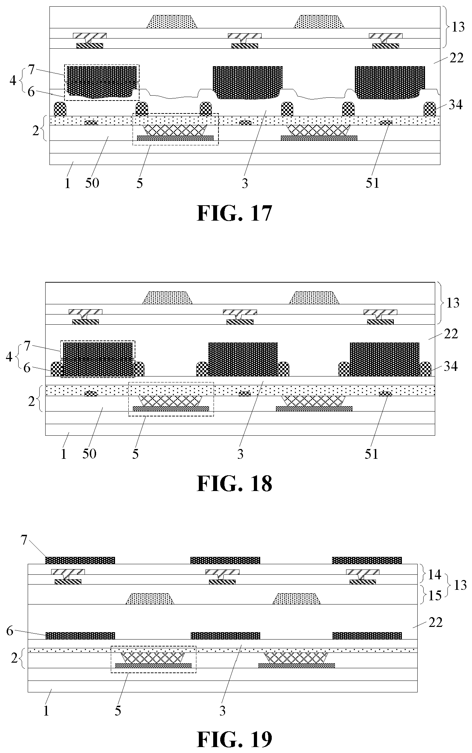

As shown in FIG. 17 and FIG. 18, FIG. 17 is another structural diagram of a display panel according to an embodiment of the present disclosure, and FIG. 18 is another structural diagram of a display panel according to an embodiment of the present disclosure. The pixel layer 2 includes a pixel definition layer 50, and the pixel definition layer includes an opening for accommodating the light-emitting layer 26. In an embodiment of the present disclosure, some support columns 51 may be provided above the pixel definition layer. The support columns 51 are configured to support a mask plate in the process of forming the light-emitting layer 26. In an embodiment of the present disclosure, a height of the second dam 34 can be greater than a height of the support columns 51, so that the second dam 34 can effectively block the flow of ink.

In an embodiment of the present disclosure, as shown in FIG. 19, which is a structural diagram of another display panel according to an embodiment of the present disclosure, the display panel further includes a light extraction layer 15 and a touch layer 14. The light extraction layer 15 and the touch layer 14 are both arranged at a side of the first blocking portion 6 facing away from the substrate 1, and the light extraction layer 15 is arranged between the first blocking portion 6 and the touch layer 14, so that the touch layer 14 is far apart from the pixel layer 2, thereby avoiding signal interference between the touch layer 14 and the pixel layer 2 to a greater extent, and ensuring touch performance.

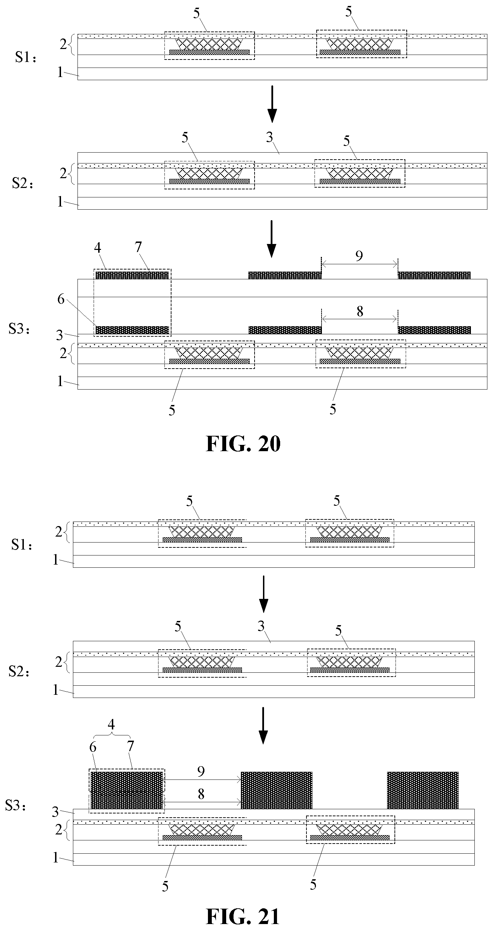

Based on the same inventive concept, an embodiment of the present disclosure further provides a method for manufacturing a display panel. In combination with FIG. 3, as shown in FIG. 20 and FIG. 21, FIG. 20 is a flowchart of a method for manufacturing the display panel according to an embodiment of the present disclosure, and FIG. 21 is another flowchart of a method for manufacturing the display panel according to an embodiment of the present disclosure. The method includes following steps.

Step S1: a pixel layer 2 is formed at a side of the substrate 1. The pixel layer 2 includes a first pixel 5.

Step S2: an encapsulation layer 3 is formed on the pixel layer 2. The encapsulation layer 3 is formed as a single-layer film structure.

Step S3: a blocking structure 4 is formed on the encapsulation layer 3. The blocking structure 4 includes a first blocking portion 6 and a second blocking portion 7. The first blocking portion 6 is arranged at a side of the encapsulation layer 3 facing away from the substrate 1, and a first opening 8 is formed between the first blocking portions 6 of adjacent blocking structures 4. The second blocking portion 7 is arranged at a side of the first blocking portion 6 facing away from the substrate 1, and a second opening 9 is formed between the second blocking portions 7 of adjacent blocking structures 4. In a direction perpendicular to a plane of the substrate 1, the first pixel 5, the first opening 8, and the second opening 9 at least partially overlap.

The encapsulation layer 3 of the display panel formed by the above-mentioned manufacturing method adopts a single-layer encapsulation design.

An encapsulation structure in such encapsulation manner is a very thin inorganic layer with a very small thickness. Therefore, when the first blocking portion 6 is arranged above the first blocking portion 6, a longitudinal distance between the first blocking portion 6 and the first pixel 5 can be greatly reduced, so that the first blocking portion 6 is very adjacent to the first pixel 5, and the first blocking portion 6 can block light emitted by the first pixel 5 at a larger angle. Meanwhile, the second blocking portion 7 is further arranged above the first blocking portion 6. Compared with the first blocking portion 6, a longitudinal distance between the second blocking portion 7 and the first pixel 5 is slightly larger, and the second blocking portion 7 can block light emitted by the first pixel 5 at a smaller angle.

By adopting the technical solution provided by the embodiments of the present disclosure, under the condition that the display panel reaches the same anti-peeping angle, a spacing between the adjacent first pixels 5 can be reduced, so that the aperture ratio of the first pixel 5 is larger, thereby effectively prolonging the service life of the first pixel 5.

In an embodiment of the present disclosure, the encapsulation layer 3 may be formed by the ALD process. A single-layer encapsulation film formed by the process has a very high compactness, effectively blocking intrusion of external substances such as water vapor, oxygen, and impurities, thereby achieving a good encapsulation effect.

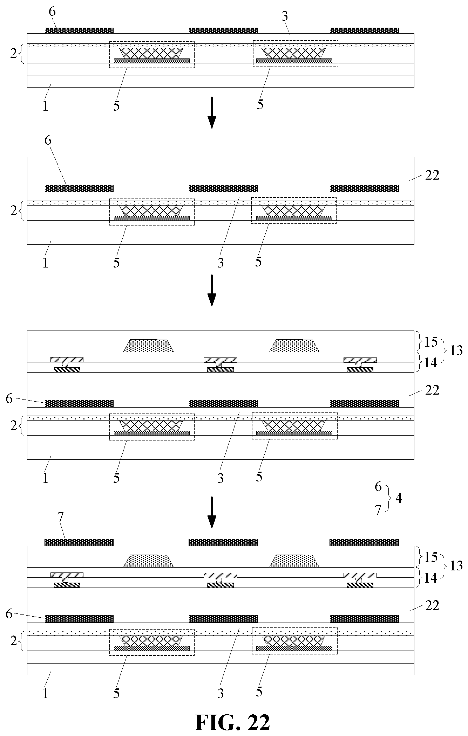

In an embodiment of the present disclosure, with reference to FIG. 8, as shown in FIG. 22, which is yet another flowchart of a method for manufacturing the display panel according to the embodiment of the present disclosure, after forming the first blocking portion 6, the manufacturing method further includes: A first layer 13 is formed on the first blocking portion 6. The first layer 13 includes a touch layer 14 and/or a light extraction layer 15. The second blocking portion 7 is formed after the first layer 13 is formed.

In the light blocking structure 4 formed by the above-mentioned method, the first layer 13 is spaced between the first blocking portion 6 and the second blocking portion 7. a longitudinal distance between the second blocking portion 7 and the first pixel 5 can be flexibly adjusted by designing parameters such as such as the number of layers and the thickness of the layers in the first layer 13, thereby adjusting a minimum shading angle that the blocking structure 4 can have, and improving the flexibility of designing the anti-peeping angle of the display panel. Therefore, under the condition that the display panel reaches the same anti-peeping angle, a spacing between adjacent first pixels 5 can be reduced, so that the aperture ratio of the first pixels 5 is greater.

Further, referring to FIG. 22 again, after forming the first blocking portion 6 and before forming the first layer 13, the method further includes: forming an organic spacer layer 22.

In the layer structure of the display panel, a thickness of the organic layer is usually much greater than a thickness of the inorganic layer. An organic spacer layer 22 is provided between the first layer 13 and the first blocking portion 6. On one hand, the organic spacer layer 22 is spaced between the touch layer 14 and the pixel layer 2, which can reduce mutual interference between the touch signal and the display signal. And/or, the organic spacer layer 22 is spaced between the light extraction layer 15 and the pixel layer 2, so that the light extraction layer 15 is far apart from the pixel layer 2, and more oblique light emitted by the first pixel 5 and the second pixel 11 can be injected into the interface between the dimming portion 20 and the dimming layer 21, thereby further improving a light extraction rate. On the other hand, the second blocking portion 7 is far apart from the first pixel 5, and the second blocking portion 7 can block light emitted by the first pixel 5 at a smaller angle, thereby improving the anti-peeping effect.

Further, the process of forming the organic spacer layer 22 includes: The organic spacer layer 22 is formed by an etching process, so that the organic spacer layer 22 has a uniform thickness and a better film flatness.

For the organic spacer layer 22 formed by the etching process, in combination with FIG. 9, the organic spacer layer 22 includes a first portion 23 arranged in the non-display area NAA and a second portion 24 at least arranged in the display area AA, and a thickness of the first portion 23 is equal to a thickness of the second portion 24.

In an embodiment of the present disclosure, the process of forming the organic spacer layer 22 may further include: The organic spacer layer 22 is formed by a printing process, so that the organic spacer layer 22 can have a larger thickness, and the thickness of the organic spacer layer 22 can be configured within a larger range, thereby facilitating more flexible adjustment of the longitudinal distance between the second blocking portion 7 and the first pixel 5 and adjustment of the shading angle of the second blocking portion 7.

For the organic spacer layer 22 formed by the printing process, during the inkjet printing process, ink droplets in the central region can be relatively uniformly overlapped and spread, while in the edge region, the deposition distribution of the droplets changes, making the thickness in the edge region smaller. That is, referring to FIG. 10, the organic spacer layer 22 includes a first portion 23 arranged in the non-display area NAA and a second portion 24 at least arranged in the display area AA. A thickness of the first portion 23 is less than a thickness of the second portion 24, for example, along a direction from the display area AA to the non-display area NAA, the thickness of the first portion 23 decreases gradually.

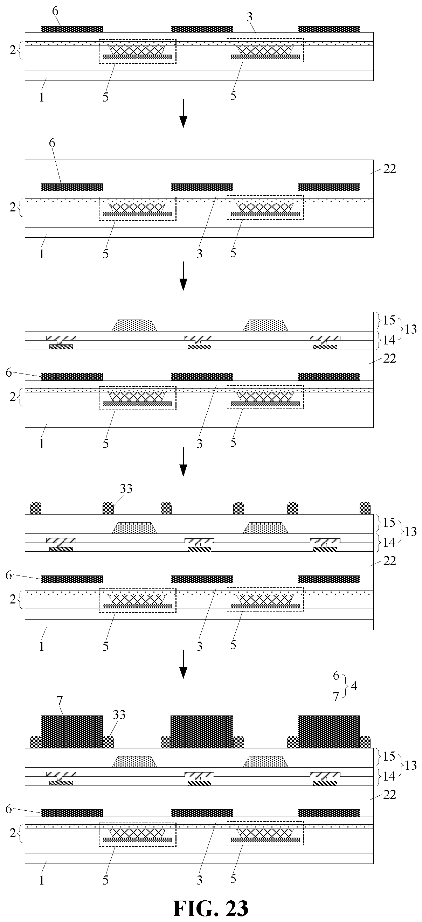

In an embodiment of the present disclosure, as shown in FIG. 23, which is another flowchart of a method for manufacturing the display panel according to the embodiment of the present disclosure, the second blocking portion 7 is formed by a printing process. Before forming the second blocking portion 7, the manufacturing method further includes: forming a first dam 33 around a printing area of the second blocking portion 7.

In an embodiment of the present disclosure, the second blocking portion 7 can be formed by the inkjet printing process. In such pixel-level inkjet printing, a first dam 33 can be provided around the printing area, to block diffusion of ink at an edge of the printing area using the first dam 33, ensuring that the ink of each pixel can be accurately deposited at a predetermined position, thereby ensuring pixel-level accuracy of a printed image. In addition, the first dam 33 can also limit and guide the flow of the ink during the printing process, so that the flow of the ink in the printing area is more stable and uniform, and the printing consistency is prevented from being affected due to uneven flow of the ink.

In an embodiment of the present disclosure, referring to FIG. 21, the process of forming the blocking structure 4 includes: forming the first blocking portion 6 and the second blocking portion 7 integrally formed by a printing process.

The first blocking portion 6 and the second blocking portion 7 formed in this way are communicated with each other without a spacing therebetween. The blocking structure 4 can form the first blocking portion 6 and the second blocking portion 7 simultaneously by only one process, and the process is simpler.

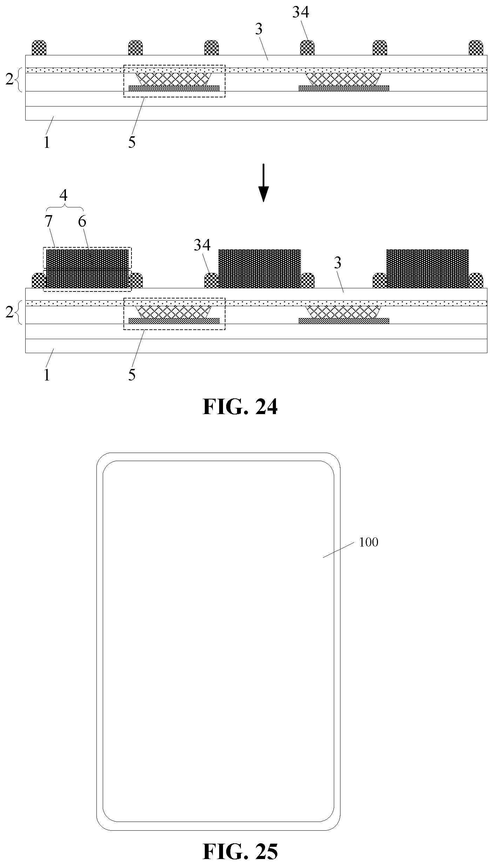

Further, as shown in FIG. 24, which is yet another flowchart of a method for manufacturing the display panel according to an embodiment of the present disclosure, after forming the pixel layer 2 and before forming the blocking structure 4, the method further includes: forming a second dam 34 around the printing area of the blocking structure 4.

In an embodiment of the present disclosure, the blocking structure 4 can be formed by an inkjet printing process. In such pixel-level inkjet printing, a second dam 34 can be arranged around the printing area, and the second dam 34 can effectively block the diffusion of ink at an edge of the printing area, ensuring that the ink of each pixel can be accurately deposited at a predetermined position, thereby ensuring pixel-level accuracy of a printed image. In addition, the second dam 34 can also limit and guide the flow of the ink during the printing process, so that the flow of the ink in the printing area is more stable and uniform, and the printing consistency is prevented from being affected due to uneven flow of the ink.

Based on the same inventive concept, an embodiment of the present disclosure further provides a display apparatus. As shown in FIG. 25, which is a structural diagram of a display apparatus according to an embodiment of the present disclosure, the display apparatus includes the above-mentioned display panel 100. It is understandable that, the display apparatus shown in FIG. 25 is merely illustrative, and the display apparatus may be any electronic device having a display function, such as a mobile phone, a tablet computer, a notebook computer, an e-book or a television.

The above description is only a preferred embodiment of the present disclosure and is not intended to limit the present disclosure, and any modifications, equivalent substitutions, improvements and the like made within the inventive concept and principle of the present disclosure should be included within the scope of the present disclosure.

Finally, it should be noted that, the above embodiments are merely used to illustrate the technical solutions of the present disclosure, but not to limit the same. Although the present disclosure has been described in detail with reference to the above embodiments, those skilled in the art should understand that the technical solutions described in the above embodiments of the present disclosure may still be modified, or some or all of the technical features may be equivalently replaced. These modifications or substitutions do not make the essence of the corresponding technical solutions depart from the scope of the technical solutions in the embodiments of the present disclosure.

## Claims

1. A display panel, comprising:
a substrate;
a pixel layer comprising a first pixel;
an encapsulation layer provided at a side of the pixel layer facing away from the substrate, wherein the encapsulation layer is a single-layer film structure; and
blocking structures, each of the blocking structures comprising a first blocking portion and a second blocking portion, wherein the first blocking portion is arranged at a side of the encapsulation layer facing away from the substrate, a first opening is formed between first blocking portions of adjacent blocking structures, the second blocking portion is arranged at a side of the first blocking portion facing away from the substrate, a second opening is formed between second blocking portions of adjacent blocking structures, and the first pixel, the first opening at least partially overlaps the second opening in a direction perpendicular to a plane of the substrate.

2. The display panel according to claim 1, wherein
the encapsulation layer comprises an oxide material.

3. The display panel according to claim 1, wherein
the pixel layer comprises a first display unit that comprises at least two first pixels of a same color arranged along a first direction;
the pixel layer further comprises a second pixel, and an area of the second pixel is greater than an area of the first pixel having a same color as the second pixel ; and
on the plane of the substrate, an orthographic projection of the first pixel has orthographic projections of the blocking structures at least at opposite sides of the first direction.

4. The display panel according to claim 3, wherein
along the first direction, the second pixel at least partially overlaps the first pixel; and
each of the blocking structures comprises a first blocking structure, on the plane of the substrate, an orthographic projection of the first blocking structure is arranged between an orthographic projection of the second pixel and an orthographic projection of the first pixel, and a distance between the orthographic projection of the first blocking structure and the orthographic projection of the second pixel is greater than a distance between the orthographic projection of the first blocking structure and the orthographic projection of the first pixel.

5. The display panel according to claim 1, wherein
a thickness of the encapsulation layer is greater than or equal to 30nm and less than or equal to 100nm.

6. The display panel according to claim 1, wherein
a spacing is formed between the first blocking portion and the second blocking portion along a direction perpendicular to the plane of the substrate.

7. The display panel according to claim 6, further comprising:
a first layer provided between the first blocking portion and the second blocking portion, wherein the first layer comprises a touch layer and/or a light extraction layer; and
an organic spacer layer provided between the first layer and the first blocking portion.

8. The display panel according to claim 7, wherein
a thickness of the organic spacer layer is greater than 10µm.

9. The display panel according to claim 7, wherein
the organic spacer layer has a dielectric constant of ε1, where 2.3≤ε1≤3.

10. The display panel according to claim 7, wherein
the organic spacer layer comprises an organic photoresist material.

11. The display panel according to claim 7, comprising:
a display area and a non-display area arranged at a side of the display area;
wherein the organic spacer layer comprises a first portion located in the non-display area and a second portion at least located in the display area, and wherein a thickness of the first portion is less than a thickness of the second portion.

12. The display panel according to claim 11, further comprising:
a blocking dam provided in the non-display area and between the organic spacer layer and an outer edge of the display panel.

13. The display panel according to claim 7, wherein
on the plane of the substrate, an orthographic projection of the organic spacer layer overlaps an orthographic projection of the encapsulation layer.

14. The display panel according to claim 6, wherein
along a first direction, a width of the first blocking portion is greater than a width of the second blocking portion.

15. The display panel according to claim 6, wherein
the first pixel comprises a light-emitting layer comprising a first top surface facing away from the substrate;
the first blocking portion comprises a first bottom surface adjacent to the substrate, and the second blocking portion comprises a second bottom surface adjacent to the substrate; and
a distance between the first top surface and the first bottom surface in the direction perpendicular to the plane of the substrate is d1, and a distance between the first top surface and the second bottom surface in the direction perpendicular to the plane of the substrate is d2, where $10 < \frac{d 2}{d 1} < 50$.

16. The display panel according to claim 6, further comprising:
a light extraction layer provided between the first blocking portion and the second blocking portion;
wherein the light extraction layer comprises dimming portions and a dimming layer covering the dimming portions, the first pixel overlaps the dimming portions in the direction perpendicular to the plane of the substrate, and the dimming portions comprise a first surface and a second surface that are opposite to each other, and a first inclined surface connected between the first surface and the second surface; and
the second blocking portion does not overlap the first inclined surface in the direction perpendicular to the plane of the substrate.

17. The display panel according to claim 6, wherein
a thickness of the first blocking portion is greater than a thickness of the second blocking portion.

18. The display panel according to claim 6, wherein
a thickness of the second blocking portion is greater than a thickness of the first blocking portion.

19. The display panel according to claim 18, wherein
the thickness of the first blocking portion is a1, and the thickness of the second blocking portion is a2, where $3 < \frac{a 2}{a 1} < 50$.

20. The display panel according to claim 6, wherein
a thickness of the second blocking portion is greater than 10µm.

21. The display panel according to claim 20, further comprising:
a first dam provided around the second blocking portion.

22. The display panel according to claim 1, wherein
the first blocking portion and the second blocking portion in the blocking structure are integrally formed.

23. The display panel according to claim 22, wherein
a thickness of the blocking structure is greater than 10µm.

24. The display panel according to claim 22, further comprising:
a second dam provided at a side of the pixel layer facing away from the substrate, wherein on the plane of the substrate, an orthographic projection of the second dam is arranged around an orthographic projection of the blocking structure.

25. The display panel according to claim 24, wherein
the second dam is arranged between the pixel layer and the encapsulation layer.

26. The display panel according to claim 25, wherein
an upper surface of the encapsulation layer facing away from the substrate is an uneven surface.

27. The display panel according to claim 24, wherein
the second dam is arranged at a side of the encapsulation layer facing away from the substrate.

28. The display panel according to claim 1, further comprising:
a light extraction layer and a touch layer;
wherein the light extraction layer and the touch layer are both arranged at a side of the first blocking portion facing away from the substrate, and the light extraction layer is arranged between the first blocking portion and the touch layer.

29. A method for manufacturing a display panel, comprising:
forming a pixel layer at a side of a substrate, wherein the pixel layer comprises a first pixel;
forming an encapsulation layer on the pixel layer, wherein the encapsulation layer is formed as a single-layer film structure; and
forming a blocking structure on the encapsulation layer, wherein the blocking structure comprises a first blocking portion and a second blocking portion, the first blocking portion is arranged at a side of the encapsulation layer facing away from the substrate, a first opening is formed between first blocking portions of adjacent blocking structures, the second blocking portion is arranged at a side of the first blocking portion facing away from the substrate, a second opening is formed between second blocking portions of adjacent blocking structures, and the first pixel, the first opening and the second opening at least partially overlap in a direction perpendicular to a plane of the substrate.

30. The method for manufacturing the display panel according to claim 29, wherein
after forming the first blocking portion, the method further comprises: forming a first layer on the first blocking portion, wherein the first layer comprises a touch layer and/or a light extraction layer; and
forming the second blocking portion after forming the first layer.

31. The method for manufacturing the display panel according to claim 30, wherein
after forming the first blocking portion and before forming the first layer, the method further comprises: forming an organic spacer layer.

32. The method for manufacturing the display panel according to claim 31, wherein
forming the organic spacer layer comprises: forming the organic spacer layer by an etching process, or forming the organic spacer layer by a printing process.

33. The method for manufacturing the display panel according to claim 30, wherein
the second blocking portion is formed by a printing process; and
before forming the second blocking portion, the method further comprises: forming a first dam arranged around a printing area of the second blocking portion.

34. The method for manufacturing the display panel according to claim 29, wherein
forming the blocking structure comprises: forming, by a printing process, the first blocking portion and the second blocking portion integrally formed.

35. The method for manufacturing the display panel according to claim 34, wherein
after forming the pixel layer and before forming the blocking structure, the method further comprises: forming a second dam arranged around a printing area of the blocking structure.

36. A display apparatus, comprising the display panel according to any one of claims 1 to 28.
